# EUROPÄISCHE PATENTSCHRIFT

(11) **EP 2 424 342 B1**
(45) Veröffentlichungstag und Bekanntmachung des Hinweises auf die Patenterteilung: **24.07.2019**
(21) Anmeldenummer: 11179237.0
(22) Anmeldetag: 30.08.2011
(51) Int. Cl.: H05K 7/20, H05B 6/12, F24C 7/08, F24C 15/10, F24C 15/00, H05B 6/06, A47J 27/00, A47J 43/07

(54) **Hausgerätevorrichtung**
Domestic appliance
Dispositif d'appareil ménager

(30) Priorität: 31.08.2010 ES 201031305
(43) Veröffentlichungstag der Anmeldung: 29.02.2012
(73) Patentinhaber: BSH Hausgeräte GmbH, 81739 München (DE)
(72) Erfinder: Anton Falcon, Daniel, 50010 Zaragoza (ES); Aranda Vazquez, Sandra, 50015 Zaragoza (ES); Buñuel Magdalena, Miguel Angel, 50017 Zaragoza (ES); Dionisio Micolau, Diego, 50013 Zaragoza (ES); Hernandez Blasco, Pablo Jesus, 50410 Cuarte de Huerva (Zaragoza) (ES); Lorente Perez, Alfonso, 50019 Zaragoza (ES); Martin Gomez, Damaso, 20012 Zaragoza (ES); Ortiz Sainz, David, 50298 Pinseque (Zaragoza) (ES); Pina Gadea, Carmelo, 50008 Zaragoza (ES); Sanchez Garcia, Eva Maria, 50013 Zaragoza (ES); Torrubia Marco, Demetrio, 50003 Zaragoza (ES)

(56) Entgegenhaltungen:
- DE-T2- 69 505 018
- DE-U1- 29 924 507
- JP-A- 2002 313 550
- JP-A- 2005 078 823
- JP-A- 2009 059 564
- JP-A- 2009 224 166
- JP-A- 2010 092 886
- JP-A- 2010 157 462
- JP-A- 2010 175 089

## Beschreibung

Die Erfindung geht aus von einer Hausgerätevorrichtung nach dem Oberbegriff des Anspruchs 1.

Es ist bekannt, eine Elektronikeinheit eines Hausgeräts mit Hilfe eines Kühlkörpers zu kühlen. Die DE 695 05 018 T2 zeigt eine Hausgerätevorrichtung nach dem Oberbegriff des Anspruchs 1.

Die Aufgabe der Erfindung besteht insbesondere darin, eine gattungsgemäße Hausgerätevorrichtung mit verbesserten Eigenschaften hinsichtlich einer Kühlung, insbesondere einer Elektronikeinheit, bereitzustellen. Die Aufgabe wird erfindungsgemäß durch die Merkmale des Patentanspruchs 1 gelöst, während vorteilhafte Ausgestaltungen und Weiterbildungen der Erfindung den Unteransprüchen entnommen werden können.

Die Erfindung geht aus von einer Hausgerätevorrichtung, insbesondere einer Gargerätevorrichtung, mit wenigstens einem Kühlkörper, insbesondere zur Kühlung einer Elektronikeinheit, und einer Hausgerätedeckplatte, wobei der Kühlkörper mit der Hausgerätedeckplatte thermisch kontaktiert ist und die Hausgerätedeckplatte zur Wärmeabfuhr vorgesehen ist. Unter "vorgesehen" soll insbesondere speziell ausgelegt und/oder ausgestattet und/oder programmiert verstanden werden. Unter einer "Hausgerätedeckplatte" soll insbesondere eine Deckplatte verstanden werden, die zur Abdeckung wenigstens einer Einheit und vorzugsweise mehrerer Einheiten vorgesehen ist und auf der insbesondere Bauteile angeordnet und/oder befestigt sind, wie insbesondere der Kühlkörper und/oder vorzugsweise zumindest eine vom Kühlkörper differierende Einheit. Unter einer "Elektronikeinheit" soll insbesondere eine Steuer- und/oder Regeleinheit und/oder Mikroprozessoreinheit und/oder Leistungselektronikeinheit verstanden werden. Unter einer "Leistungselektronikeinheit" ist insbesondere eine Elektronikeinheit zu verstehen, die dazu vorgesehen ist, einen elektrischen Verbraucher mit einer Spitzenleistung von zumindest 500 W, insbesondere von wenigstens 1000 W, vorteilhaft von mindestens 1500 W und besonders vorteilhaft von zumindest 2000 W zu betreiben und die vorzugsweise einen Stromrichter, insbesondere einen Gleichrichter und/oder einen Wechselrichter und/oder einen Gleichstromsteller und/oder einen Frequenzumrichter umfasst.

Unter einem "Kühlkörper" soll insbesondere eine Einheit verstanden werden, die gezielt zur Kühlung weiterer Bauteile, insbesondere einer Elektronikeinheit, ausgebildet ist und insbesondere mit diesen Bauteilen in thermischem und vorzugsweise in direktem mechanischen Kontakt steht. Der Kühlkörper weist zur Abgabe von Wärmeenergie an die Umgebung insbesondere eine zumindest 5-fach, insbesondere wenigstens 10-fach, vorteilhaft wenigstens 20-fach und besonders vorteilhaft zumindest 50-fach größere Oberfläche auf als ein Würfel gleichen Volumens und umfasst insbesondere zumindest 3, vorzugsweise wenigstens 10 und besonders vorteilhaft mindestens 20 Kühlrippen. Hierbei soll unter einer "Kühlrippe" ein längliches, insbesondere wand- oder stabförmiges, Bauelement aus einem wärmeleitenden Material verstanden werden, das zumindest an einer Stelle mit einem Grundkörper des Kühlkörpers, insbesondere einstückig, verbunden ist. Unter einem "Grundkörper des Kühlkörpers" soll insbesondere ein Bauelement aus einem wärmeleitenden Material verstanden werden, das zumindest eine Oberfläche aufweist, die in thermischem Kontakt mit einem zu kühlendenBauteil steht. Vorzugsweise besteht der gesamte Kühlkörper aus einem wärmeleitenden Material und weist insbesondere einen plattenförmigen Grundkörper auf, von dem Kühlrippen, vorzugsweise nur auf einer Seite des Grundkörpers, ausgehen. Insbesondere kann der Kühlkörper speziell zu einem Wärmeübertrag auf eine an zumindest einer der Oberflächen des Kühlkörpers entlang strömende Luftströmung ausgelegt sein und verfügt vorzugsweise über Luftströmungskanäle, durch die eine Luftströmung zur Kühlung des Kühlkörpers geführt wird. Hierbei soll unter einem "Luftströmungskanal" insbesondere eine Baueinheit verstanden werden, die zumindest teilweise zu einer Führung eines Luftstroms vorgesehen ist, und die den Luftstrom in Strömungsrichtung gesehen unmittelbar zumindest teilweise, vorzugsweise auf drei Seiten und besonders vorteilhaft vollständig umschließt. Vorzugsweise ist eine Haupterstreckung des Luftströmungskanals parallel zur Strömungsrichtung des Luftstroms und zumindest 2-mal, insbesondere wenigstens 5-mal und vorteilhaft zumindest 10-mal länger als wenigstens eine Querschnittserstreckung des Luftströmungskanals. Unter einer "Strömungsrichtung" soll insbesondere eine Richtung einer Nettoströmung und insbesondere eine Richtung eines mittleren Massetransports in einer Strömung verstanden werden.

Unter einem "wärmeleitenden Material" soll insbesondere ein Material mit einer Wärmeleitfähigkeit von wenigstens 5 Wm⁻¹K⁻¹, insbesondere zumindest 15 Wm⁻¹K⁻¹, vorteilhaft mindestens 100 Wm⁻¹K⁻¹ und besonders vorteilhaft wenigstens 200 Wm⁻¹K⁻¹ verstanden werden. Darunter, dass der Kühlkörper und zumindest ein weiteres Bauteil "thermisch kontaktiert" sind oder "in thermischem Kontakt" stehen, soll insbesondere verstanden werden, dass der Kühlkörper und das weitere Bauteil in einem montierten Zustand der Hausgerätevorrichtung Wärmeenergie austauschen können und dass vorzugsweise ein Wärmeübergangskoeffizient dieses Austauschs größer ist als ein Wärmeübergangskoeffizient eines Austauschs von Wärmeenergie zwischen dem Kühlkörper und dem weiteren Bauteil über einen Luftspalt. Vorzugsweise stehen der Kühlkörper und das weitere Bauteil in direktem Kontakt und liegen insbesondere zumindest in einem Teilbereich unmittelbar aneinander an und sind vorzugsweise fest miteinander verbunden, so dass zumindest 60%, insbesondere zumindest 70%, vorteilhaft wenigstens 80% und besonders vorteilhaft mindestens 90% der Wärmeenergie über eine Festkörperkontaktstelle oder mehrere Festkörperkontaktstellen übertragen wird. Darunter, dass die Hausgerätedeckplatte "zur Wärmeabfuhr vorgesehen" ist, soll insbesondere verstanden werden, dass die Hausgerätedeckplatte zumindest teilweise aus einem wärmeleitenden Material besteht.

Dadurch, dass der Kühlkörper mit der Hausgerätedeckplatte thermisch kontaktiert ist, kann ein Wärmereservoir angeboten werden, wodurch eine Kühlung, insbesondere einer Elektronikeinheit, vorteilhaft verbessert werden kann. Eine weitere Verbesserung der Kühlung, insbesondere der Elektronikeinheit, kann erreicht werden, wenn zwischen Kühlkörper und Hausgerätedeckplatte ein dünn aufgetragenes, fluides Wärmeleitmedium, insbesondere eine Wärmeleitpaste, eingebracht ist, welches Unebenheiten in den Kontaktoberflächen des Kühlkörpers und der Hausgerätedeckplatte ausgleicht. Ein vorteilhaft großes Wärmereservoir kann erreicht werden, wenn die Hausgerätedeckplatte eine Dicke von mindestens 1 mm, insbesondere von mindestens 2 mm, vorzugsweise von mindestens 3 mm und besonders bevorzugt von mindestens 5 mm aufweist.

Die Hausgerätevorrichtung weist eine Luftströmungseinheit auf, die dazu vorgesehen ist, einen Luftstrom während zumindest eines Betriebsmodus zum Kühlkörper zu führen. Unter einer "Luftströmungseinheit" soll insbesondere eine Einheit verstanden werden, die an zumindest einem Ort einen Luftstrom bereitstellt. Hierunter soll insbesondere verstanden werden, dass die Luftströmungseinheit dazu vorgesehen ist, zumindest einen Luftstrom zu erzeugen, insbesondere mittels wenigstens einer Lüftereinheit, und/oder zumindest eine teilweise Führung für einen Luftstrom bereitzustellen und/oder zumindest einen Luftstrom zu teilen. Unter einer "Lüftereinheit" soll insbesondere eine Einheit verstanden werden, die einen Luftstrom, insbesondere durch elektrische Energie, erzeugt und die vorzugsweise ein speziell angeformtes, rotierendes Lüftergebläserad aufweist, welches Luft an wenigstens einer Seite ansaugt und an zumindest einer anderen Seite ausstößt. Vorzugsweise bewirkt die Luftströmungseinheit durch zumindest eine Druckänderung im Luftstrom und/oder durch eine Orientierung zumindest einer Oberfläche relativ zu einer Strömungsrichtung eine Führung und/oder Teilung des Luftstroms. Vorteilhaft wird die Druckänderung durch eine Geometrie der Luftströmungseinheit bewirkt, insbesondere durch eine Form einer Oberfläche und/oder durch eine Orientierung zumindest einer Oberfläche relativ zu einem Luftstrom und/oder durch eine Veränderung einer Querschnittsfläche eines Luftströmungskanals. Durch eine solche Ausgestaltung kann eine Wärmeabfuhr am Kühlkörper vorteilhaft gesteigert werden, indem erwärmte Luft abgeführt und durch kühlere Luft ersetzt wird.

Die Luftströmungseinheit ist dazu vorgesehen, zumindest einen Luftstrom zumindest teilweise entlang einer ersten Seite der Hausgerätedeckplatte und zumindest einen Luftstrom zumindest teilweise entlang einer der ersten Seite gegenüberliegenden zweiten Seite der Hausgerätedeckplatte zu führen. Hierbei soll unter einer "ersten Seite der Hausgerätedeckplatte" insbesondere eine Seite der Hausgerätedeckplatte verstanden werden, auf der sich die wenigstens eine abgedeckte Einheit befindet und auf der insbesondere Bauteile angeordnet und/oder befestigt sind, wie insbesondere der Kühlkörper und/oder vorzugsweise zumindest eine von dem Kühlkörper differierende Einheit. Unter einer "zweiten Seite der Hausgerätedeckplatte" soll insbesondere eine der ersten Seite gegenüberliegende Seite der Hausgerätedeckplatte verstanden werden. Die Strömungseinheit verfügt insbesondere über zumindest eine Einheit, die jeweils einen Luftstrom auf beiden Seiten der Hausgerätedeckplatte erzeugt. Insbesondere kann diese Einheit zumindest eine Lüftereinheit und ein Luftleitmittel zur Umlenkung und/oder Teilung eines durch die Lüftereinheit erzeugten Luftstroms aufweisen und/oder jeweils zumindest eine Lüftereinheit auf jeder Seite der Hausgerätedeckplatte umfassen. Unter einem "Luftleitmittel" ist hierbei und im Folgenden insbesondere ein Mittel zu verstehen, welches durch zumindest eine Druckänderung im Luftstrom und/oder durch eine Orientierung zumindest einer Oberfläche relativ zu einer Strömungsrichtung eine Umlenkung zumindest eines Teils desLuftstroms bewirkt. Vorteilhaft wird die Druckänderung durch eine Geometrie des Luftleitmittels bewirkt, insbesondere durch eine Form einer Oberfläche des Luftleitmittels und/oder durch eine Orientierung zumindest einer Oberfläche des Luftleitmittels relativ zu einem Luftstrom und/oder durch eine Veränderung einer Querschnittsfläche eines Luftströmungskanals. Durch diese Ausgestaltung kann eine vorteilhafte Kühlung der Hausgerätedeckplatte erreicht werden. Vorzugsweise ist die Luftströmungseinheit zumindest teilweise einstückig mit der Hausgerätedeckplatte ausgebildet. Hierdurch können Material, Gewicht, Bauraum und Kosten eingespart und ein Fertigungsaufwand kann vorteilhaft reduziert werden.

Die Luftströmungseinheit weist wenigstens ein Luftleitmittel auf, das dazu vorgesehen ist, wenigstens einen Teil des Luftstroms von der ersten Seite der Hausgerätedeckplatte auf die zweite Seite der Hausgerätedeckplatte umzulenken. Hierdurch kann mit nur einer Lüftereinheit oberhalb der ersten Seite der Hausgerätedeckplatte ein Luftstrom auf beiden Seiten der Hausgerätedeckplatte erreicht werden. Vorteilhaft beträgt ein Volumenstrom des umgelenkten Teils des Luftstroms höchstens 40%, insbesondere höchstens 30%, vorteilhaft höchstens 20% und besonders vorteilhaft höchstens 10% eines Volumenstroms des Luftstroms auf der ersten Seite der Hausgerätedeckplatte in Strömungsrichtung vor dem Luftleitmittel. Hierdurch kann ein ausreichend hoher Volumenstrom durch den Kühlkörper sichergestellt werden.

Vorteilhaft weist die Hausgerätedeckplatte eine Ausnehmung auf, durch die das Luftleitmittel in wenigstens einem Betriebsmodus den wenigstens einen Teil des Luftstroms führt. Hierdurch kann auf einfache und platzsparende Weise ein Luftstrom auf beiden Seiten der Hausgerätedeckplatte erreicht werden. Mit Vorteil ist zumindest ein die Ausnehmung begrenzender Rand der Hausgerätedeckplatte dazu vorgesehen, eine anströmende Luftströmung aufzuspalten, vorzugsweise in einen Luftstrom auf der ersten Seite der Hausgerätedeckplatte und einen Luftstrom auf der zweiten Seite der Hausgerätedeckplatte. Hierdurch kann konstruktiv einfach eine Aufspaltung und Trennung eines Luftstroms erzielt werden.

Ferner wird vorgeschlagen, dass das Luftleitmittel zumindest teilweise einstückig mit der Hausgerätedeckplatte ausgebildet ist. Insbesondere kann das Luftleitmittel durch einen in eine Normalenrichtung der Hausgerätedeckplatte aufgebogenen Bereich gebildet sein, insbesondere einem Strömungsflügel. Hierdurch können Material, Gewicht, Bauraum und Kosten eingespart werden und ein Fertigungsaufwand kann vorteilhaft reduziert werden. Vorteilhaft ist der aufgebogene Bereich in Richtung der zweiten Seite der Hausgerätedeckplatte gebogen. Hierdurch kann erreicht werden, dass ein umgelenkter Teil der Luftströmung vorteilhaft klein bleibt und insbesondere kleiner bleibt als ein Luftstrom im Kühlkörper.

Besonders vorteilhaft ist das Luftleitmittel in Strömungsrichtung vor dem Kühlkörper angeordnet. Hierdurch kann eine vorteilhafte Kühlung der Hausgerätedeckplatte erreicht werden.

In einer bevorzugten Ausgestaltung wird vorgeschlagen, dass die Luftströmungseinheit wenigstens eine Lüftereinheit umfasst und die Hausgerätedeckplatte wenigstens eine Ausnehmung aufweist, durch die die Lüftereinheit in wenigstens einem Betriebsmodus Kühlluft ansaugt. Hierdurch kann erreicht werden, dass Kühlluft von einer kälteren Seite der Hausgerätedeckplatte zu einer wärmeren Seite der Hausgerätedeckplatte transportiert wird, was eine effektive Kühlung, insbesondere einer Elektronikeinheit, ermöglicht.

In einer besonders bevorzugten Ausgestaltung wird vorgeschlagen, dass die Hausgerätedeckplatte zumindest teilweise aus Metall gebildet ist. Hierdurch kann eine kostengünstige und stabile Hausgerätedeckplatte bereitgestellt werden. Vorzugsweise ist die Hausgerätedeckplatte vollständig aus Metall gebildet. Vorteilhaft ist die Hausgerätedeckplatte zumindest teilweise aus einem Metall mit einem Wärmeleitkoeffizienten von wenigstens 100Wm⁻¹K⁻¹, insbesondere von mindestens 150 Wm⁻¹K⁻¹ und besonders vorteilhaft von wenigstens 200 Wm⁻¹K⁻¹ gebildet, insbesondere aus einem Aluminiumblech. Hierdurch kann eine Wärmeabfuhr vom Kühlkörper vorteilhaft gesteigert werden.

Ferner wird vorgeschlagen, dass die Hausgerätedeckplatte von einer Hausgeräteabschlussplatte gebildet ist. Unter einer "Hausgeräteabschlussplatte" soll insbesondere eine Hausgerätedeckplatte verstanden werden, die zumindest eine äußere Oberfläche eines Gerätegehäuses eines Hausgeräts aufweist und die insbesondere in einem montierten Zustand des Hausgeräts vor einem Einbau in ein Küchenmöbel anfassbar ist. Insbesondere kann die Hausgeräteabschlussplatte als Bodenplatte eines Hausgeräts und insbesondere als eine einer Kochfeldplatte gegenüberliegende Bodenplatte eines Kochfelds ausgebildet sein. Durch diese Ausgestaltung kann eine einfache und platzsparende Konstruktion erreicht werden, bei der die durch den Kühlkörper aufgewärmte Hausgerätedeckplatte vorteilhaft an einer äußeren Oberfläche des Gerätegehäuses liegt und damit Wärmeenergie effektiv aus dem Gerätegehäuse abgeführt werden kann.

Ferner wird ein Hausgerät, insbesondere ein Gargerät, mit einer erfindungsgemäßen Hausgerätevorrichtung vorgeschlagen.

Weitere Vorteile ergeben sich aus der folgenden Zeichnungsbeschreibung. In der Zeichnung ist ein Ausführungsbeispiel der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

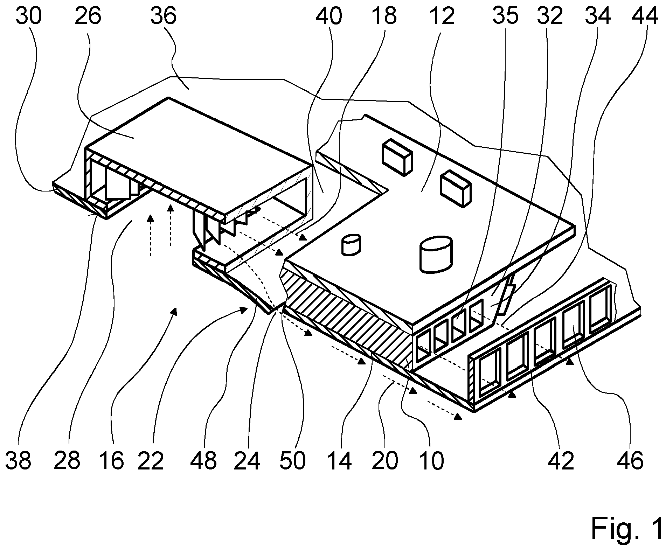

Fig. 1 zeigt eine Hausgerätevorrichtung eines Induktionskochfelds mit einem Kühlkörper 10 aus Aluminium, der zur Kühlung einer Elektronikeinheit 12 vorgesehen ist. Ein Grundkörper 32 des Kühlkörpers 10 weist die Form eines geraden Prismas auf. Eine Grundfläche 34 des geraden Prismas weist die Form eines symmetrischen Trapezes auf. Die trapezförmige Grundfläche 34 weist im Vergleich zu den beiden zueinander parallelen Seiten kurze Schenkelseiten auf. Ferner verfügt der Grundkörper 32 über tunnelförmige Ausnehmungen, die senkrecht zur Grundfläche 34 angeordnete Luftströmungskanäle 35 bilden. Die Luftströmungskanäle 35 weisen jeweils einen rechteckigen Querschnitt auf. Eine größte Mantelfläche des Grundkörpers 32 des Kühlkörpers 10 ist mit der Elektronikeinheit 12 verklebt. Bei der Elektronikeinheit 12 handelt es sich um eine Leistungselektronikeinheit, die dazu vorgesehen ist, in bekannter Weise einen hochfrequenten Wechselstrom zum Betrieb von nicht näher gezeigten Induktorspulen zu erzeugen. Die Leistungselektronikeinheit verfügt hierzu über Wechselrichter, in denen IGBTs (Insulated-Gate Bipolar Transistor) verbaut sind, die im Betrieb Verlustwärme erzeugen und gekühlt werden müssen. Ferner verfügt die Hausgerätevorrichtung über eine Hausgerätedeckplatte 14 aus Aluminium, die mit einer zweitgrößten Mantelfläche des Grundkörpers 32 des Kühlkörpers 10 durch Berührung thermisch kontaktiert ist und welche zur Wärmeabfuhr vorgesehen ist. Zusätzlich kann zwischen dem Kühlkörper 10 und der Hausgerätedeckplatte 14 eine Wärmeleitpaste vorgesehen sein, um Unebenheiten der Kontaktoberflächen auszugleichen und hierdurch einen Wärmeübertrag zwischen dem Kühlkörper 10 und der Hausgerätedeckplatte 14 vorteilhaft zu erhöhen. Durch die thermische Kontaktierung von Kühlkörper 10 und Hausgerätedeckplatte 14 wird ein vorteilhaft großes Wärmereservoir bereitgestellt, das während eines Betriebs der Elektronikeinheit 12 einen Teil der in der Elektronikeinheit 12 erzeugten Verlustwärme über den Kühlkörper 10 zugeführt bekommt und diese Wärmeenergie aufnehmen kann. Die Hausgerätedeckplatte 14 stellt eine Hausgeräteabschlussplatte 30 und zwar eine Bodenplatte eines Induktionskochfelds dar, die parallel zu einer nicht dargestellten Kochfeldplatte angeordnet ist.

Die Hausgerätevorrichtung verfügt ferner über eine Luftströmungseinheit 16, die dazu vorgesehen ist, einen ersten Luftstrom 18 während zumindest eines Betriebsmodus zum Kühlkörper 10 zu führen. Des Weiteren ist die Luftströmungseinheit 16 dazu vorgesehen, zumindest den ersten Luftstrom 18 zumindest teilweise entlang einer Oberseite 36 der Hausgerätedeckplatte 14 und zumindest einen zweiten Luftstrom 20 zumindest teilweise entlang einer der Oberseite 36 gegenüberliegenden Unterseite 38 der Hausgerätedeckplatte 14 zu führen. Hierzu weist die Luftströmungseinheit 16 eine auf der Oberseite 36 der Hausgerätedeckplatte 14 befestigte Lüftereinheit 26, einen in Fig. 1 aufgeschnitten dargestellten Luftströmungskanal 40, ein Luftleitmittel 22 und einen Luftauslass 42 auf. Die Lüftereinheit 26 saugt in wenigstens einem Betriebsmodus Kühlluft von derUnterseite 38 her durch eine Ausnehmung 28 in der Hausgerätedeckplatte 14 ineinem Winkel kleiner 45° zu einer Flächennormalen der Unterseite 38 an. Die Lüftereinheit 26 stößt in wenigstens einem Betriebsmodus die Kühlluft als Luftstrom 18 oberhalb der Oberseite 36 der Hausgerätedeckplatte 14 unter einem Winkel kleiner 30° zur Oberseite 36 aus. Dieser erste Luftstrom 18 wird im Luftströmungskanal 40 über das Luftleitmittel 22 zum Kühlkörper 10 geführt. Hinter dem Kühlkörper 10 verlässt ein aufgewärmter Luftstrom 44 die Hausgerätevorrichtung durch Auslassöffnungen 46 des Luftauslasses 42 des Induktionskochfelds.

Das in Strömungsrichtung des ersten Luftstroms 18 vor dem Kühlkörper 10 und direkt hinter einer Auslassöffnung der Lüftereinheit 26 angeordnete Luftleitmittel 22, das einstückig mit der Hausgerätedeckplatte 14 ausgebildet ist, ist dazu vorgesehen, einen Teil des ersten Luftstroms 18 von der Oberseite 36 der Hausgerätedeckplatte 14 auf die Unterseite 38 der Hausgerätedeckplatte 14 umzulenken. Das Luftleitmittel 22 umfasst einen in Strömungsrichtung des Luftstroms 18 leicht in Richtung der Unterseite 38 umgebogenen Teilbereich 48 der Hausgerätedeckplatte 14. Ein den Teilbereich 48 in Strömungsrichtung des Luftstroms 18 begrenzender Rand weist einen senkrechten Abstand zur Hausgerätedeckplatte 14 auf. Der Rand und eine Kante 50 der Hausgerätedeckplatte 14 begrenzen eine Ausnehmung 24 der Hausgerätedeckplatte 14, durch die das Luftleitmittel 22 in wenigstens einem Betriebsmodus einen Teil des Luftstroms 18 führt. Die Kante 50 ist ebenfalls Teil des Luftleitmittels 22 und ist zu einer Trennung des Luftstroms 20 vom Luftstrom 18 vorgesehen. Das Luftleitmittel 22 wurde durch Stanzen eines Schlitzes in die Hausgerätedeckplatte 14 und anschließendes Tiefziehen eines ersten, am Schlitz angrenzenden Rands der Hausgerätedeckplatte 14 auf einer der Lüftereinheit 26 zugewandten Seite des Schlitzes in Richtung der Unterseite 38 gefertigt. Ein in seiner ursprünglichen Position verbleibender zweiter, am Schlitz angrenzender Rand der Hausgerätedeckplatte 14 stellt die Kante 50 der Hausgerätedeckplatte 14 dar. Alternativ kann das Tiefziehen der Hausgerätedeckplatte 14 auch an einem zweiten Rand des Schlitzes und in Richtung der Oberseite 36 der Hausgerätedeckplatte 14 erfolgen. Hierdurch kann ein Luftleitmittel 22 erzielt werden, das in den Luftstrom 18 hineinragt und so einen deutlich größeren Anteil des Luftstroms 18 auf die Unterseite 38 derausgerätedeckplatte 14 umlenkt. Der auf die Unterseite 38 der Hausgerätedeckplatte 14 umgelenkte Teil des ersten Luftstroms 18 bildet den zweiten Luftstrom 20, dessen Strömungsrichtung im Wesentlichen parallel zur Unterseite 38 der Hausgerätedeckplatte 14 ausgerichtet ist. Da die Hausgerätedeckplatte 14 eine Hausgeräteabschlussplatte 30 des Induktionskochfelds ist, verläuft der Luftstrom 20 außerhalb eines Gerätegehäuses des Induktionskochfelds. Von der Hausgeräteabschlussplatte 30 auf den Luftstrom 20 übertragene Wärmeenergie wird somit direkt abgeführt.

### Bezugszeichen

- 10: Kühlkörper
- 12: Elektronikeinheit
- 14: Hausgerätedeckplatte
- 16: Luftströmungseinheit
- 18: Luftstrom
- 20: Luftstrom
- 22: Luftleitmittel
- 24: Ausnehmung
- 26: Lüftereinheit
- 28: Ausnehmung
- 30: Hausgeräteabschlussplatte
- 32: Grundkörper
- 34: Grundfläche
- 35: Luftströmungskanal
- 36: Oberseite
- 38: Unterseite
- 40: Luftströmungskanal
- 42: Luftauslass
- 44: Luftstrom
- 46: Auslassöffnung
- 48: Teilbereich
- 50: Kante

## Patentansprüche

1. Hausgerätevorrichtung, insbesondere Gargerätevorrichtung, mit wenigstens einem Kühlkörper (10), insbesondere zur Kühlung einer Elektronikeinheit (12), und einer Hausgerätedeckplatte (14), wobei der Kühlkörper (10) mit der Hausgerätedeckplatte (14) thermisch kontaktiert ist und die Hausgerätedeckplatte (14) zur Wärmeabfuhr vorgesehen ist, und mit einer Luftströmungseinheit (16), die dazu vorgesehen ist, einen Luftstrom (18) während zumindest eines Betriebsmodus zum Kühlkörper (10) zu führen, wobei die Luftströmungseinheit (16) dazu vorgesehen ist, zumindest einen Luftstrom (18) zumindest teilweise entlang einer ersten Seite der Hausgerätedeckplatte (14) und zumindest einen Luftstrom (20) zumindest teilweise entlang einer der ersten Seite gegenüberliegenden zweiten Seite der Hausgerätedeckplatte (14) zu führen, **dadurch gekennzeichnet, dass** die Luftströmungseinheit (16) wenigstens ein Luftleitmittel (22) aufweist, das dazu vorgesehen ist, wenigstens einen Teil des Luftstroms (18) von der ersten Seite der Hausgerätedeckplatte (14) auf die zweite Seite der Hausgerätedeckplatte (14) umzulenken.

2. Hausgerätevorrichtung nach Anspruch 1, **dadurch gekennzeichnet, dass** die Hausgerätedeckplatte (14) eine Ausnehmung (24) aufweist, durch die das Luftleitmittel (22) in wenigstens einem Betriebsmodus den wenigstens einen Teil des Luftstroms (18) führt.

3. Hausgerätevorrichtung nach Anspruch 1 oder 2, **dadurch gekennzeichnet, dass** das Luftleitmittel (22) zumindest teilweise einstückig mit der Hausgerätedeckplatte (14) ausgebildet ist.

4. Hausgerätevorrichtung nach einem der Ansprüche 1 bis 3, **dadurch gekennzeichnet, dass** das Luftleitmittel (22) in Strömungsrichtung vor dem Kühlkörper (10) angeordnet ist.

5. Hausgerätevorrichtung nach einem der Ansprüche 1 bis 4, **dadurch gekennzeichnet, dass** die Luftströmungseinheit (16) wenigstens eine Lüftereinheit (26) umfasst und die Hausgerätedeckplatte (14) wenigstens eine Ausnehmung (28) aufweist, durch die die Lüftereinheit (26) in wenigstens einem Betriebsmodus Kühlluft ansaugt.

6. Hausgerätevorrichtung nach einem der vorhergehenden Ansprüche, **dadurch gekennzeichnet, dass** die Hausgerätedeckplatte (14) zumindest teilweise aus Metall gebildet ist.

7. Hausgerätevorrichtung nach einem der vorhergehenden Ansprüche, **dadurch gekennzeichnet, dass** die Hausgerätedeckplatte (14) von einer Hausgeräteabschlussplatte (30) gebildet ist.

8. Hausgerät, insbesondere Gargerät, mit einer Hausgerätevorrichtung nach einem der vorhergehenden Ansprüche.

## Claims

1. Household appliance device, in particular cooking appliance device, having at least one cooling element (10), in particular for cooling an electronic unit (12), and a household appliance cover plate (14), wherein the cooling element (10) is in thermal contact with the household appliance cover plate (14) and the household appliance cover plate (14) is provided for discharging heat, and having an air flow unit (16), which is provided to guide an air flow (18) to the cooling element (10) during at least one operating mode, wherein the air flow unit (16) is provided to guide at least one air flow (18) at least partially along a first side of the household appliance cover plate (14) and at least one air flow (20) at least partially along a second side of the household appliance cover plate (14) which opposes the first side, **characterised in that** the air flow unit (16) has at least one air guiding means (22), which is provided to deflect at least one part of the air flow (18) from the first side of the household appliance cover plate (14) to the second side of the household appliance cover plate (14).

2. Household appliance device according to claim 1, **characterised in that** the household appliance cover plate (14) has a cut-out (24), through which the air guiding means (22) guides the at least one part of the air flow (18) in at least one operating mode.

3. Household appliance device according to claim 1 or 2, **characterised in that** the air guiding means (22) is embodied at least partially in one piece with the household appliance cover plate (14).

4. Household appliance device according to one of claims 1 to 3, **characterised in that** the air guiding means (22) is arranged upstream of the cooling element (10) in the flow direction.

5. Household appliance device according to one of claims 1 to 4, **characterised in that** the air flow unit (16) comprises at least one fan unit (26) and the household appliance cover plate (14) has at least one cut-out (28) through which the fan unit (26) sucks in cooling air in at least one operating mode.

6. Household appliance device according to one of the preceding claims, **characterised in that** the household appliance cover plate (14) is formed at least partially from metal.

7. Household appliance device according to one of the preceding claims, **characterised in that** the household appliance cover plate (14) is formed of a household appliance closing plate (30).

8. Household appliance, in particular cooking appliance, having a household appliance device according to one of the preceding claims.

## Revendications

1. Dispositif d'appareil ménager, en particulier dispositif d'appareil de cuisson, comportant au moins un corps de refroidissement (10), en particulier pour refroidir une unité électronique (12), et une plaque de couverture de l'appareil ménager (14), le corps de refroidissement (10) étant en contact thermique avec la plaque de couverture de l'appareil ménager (14) et la plaque de couverture de l'appareil ménager (14) étant prévue pour évacuer la chaleur, et avec une unité de flux d'air (16), qui est prévue pour guider un flux d'air (18) pendant au moins un mode de fonctionnement vers le corps de refroidissement (10), l'unité de flux d'air (16) étant prévue pour au moins guider un flux d'air (18) au moins en partie le long d'un premier côté de la plaque de couverture de l'appareil ménager (14) et au moins un flux d'air (20) au moins en partie le long d'un deuxième côté, faisant face au premier côté, de la plaque de couverture de l'appareil ménager (14), **caractérisé en ce que** l'unité de flux d'air (16) comporte au moins un moyen de conduite d'air (22) qui est prévu pour dévier au moins une partie du flux d'air (18) du premier côté de la plaque de couverture de l'appareil ménager (14) sur le deuxième côté de la plaque de couverture de l'appareil ménager (14).

2. Dispositif d'appareil ménager selon la revendication 1, **caractérisé en ce que** la plaque de couverture de l'appareil ménager (14) comporte un évidement (24) à travers lequel le moyen de conduite d'air (22) conduit dans au moins un mode de fonctionnement la au moins une partie du flux d'air (18).

3. Dispositif d'appareil ménager selon la revendication 1 ou 2, **caractérisé en ce que** le moyen de conduite d'air (22) est réalisé au moins en partie d'un seul tenant avec la plaque de couverture de l'appareil ménager (14).

4. Dispositif d'appareil ménager selon l'une des revendications 1 à 3, **caractérisé en ce que** le moyen de conduite d'air (22) est disposé dans le sens du flux avant le corps de refroidissement (10).

5. Dispositif d'appareil ménager selon l'une des revendications 1 à 4, **caractérisé en ce que** l'unité de flux d'air (16) comprend au moins une unité de ventilation (26) et **en ce que** la plaque de couverture de l'appareil ménager (14) comporte au moins un évidement (28) à travers lequel l'unité de ventilation (26) aspire de l'air de refroidissement dans au moins un mode de fonctionnement.

6. Dispositif d'appareil ménager selon l'une des revendications précédentes, **caractérisé en ce que** la plaque de couverture de l'appareil ménager (14) est formée, au moins en partie, en métal.

7. Dispositif d'appareil ménager selon l'une des revendications précédentes, **caractérisé en ce que** la plaque de couverture de l'appareil ménager (14) est formée d'une plaque de fermeture de l'appareil ménager (30).

8. Appareil ménager, plus précisément appareil de cuisson, comportant un dispositif d'appareil ménager selon l'une des revendications précédentes.
